# EUROPÄISCHE PATENTSCHRIFT

(11) **EP 0 890 880 B1**
(45) Veröffentlichungstag und Bekanntmachung des Hinweises auf die Patenterteilung: **19.09.2001**
(21) Anmeldenummer: 98111315.2
(22) Anmeldetag: 19.06.1998
(51) Int. Cl.: G03F 7/20, G03F 9/00

(54) **Vorrichtung zur Bearbeitung von Druckplatten**
Device for processing printing plates
Appareil pour le traitement de plaques d'impression

(30) Priorität: 09.07.1997 DE 19729310
(43) Veröffentlichungstag der Anmeldung: 13.01.1999
(73) Patentinhaber: Krause-Biagosch GmbH, D-33649 Bielefeld (DE)
(72) Erfinder: Fischer, Hermann, 86159 Augsburg (DE); Kozian, Volker, 33613 Bielefeld (DE); Günther, Alfons, 33739 Bielefeld (DE)
(74) Vertreter: Munk, Ludwig, Dipl.-Ing.

(56) Entgegenhaltungen:
- DE-A- 4 038 544
- DE-C- 4 105 269

## Beschreibung

Die Erfindung betrifft eine Vorrichtung zur Bearbeitung von Druckplatten gemäß Oberbegriff des Anspruchs 1.

Eine Vorrichtung dieser Art ist aus der DE 40 38 545 A1 bekannt. Bei dieser bekannten Vorrichtung ist das Plattenstapelmagazin mit einem endlos umlaufenden Paternoster versehen, an dem die Träger pendelnd aufgehängt sind. Eine Anordnung dieser Art ergibt eine voluminöse Bauweise. Außerdem kann die pendelnde Aufhängung der Träger zu Störungen führen. Bei der bekannten Vorrichtung befindet sich die dem Anleger zugeordnete Bestückungsposition außerhalb des Paternosters. Der in die Bestückungsposition zu verbringende Träger muß daher aus dem Paternoster herausgenommen und neben diesem plaziert werden. Dies ist umständlich und kann zu weiteren Störungen führen.

Die DE 41 05 269 C1 zeigt eine ähnliche Vorrichtung zur Bearbeitung von Druckplatten mit einem Plattenstapelmagazin, das mehrere, jeweils einen Plattenstapel aufnehmende Träger enthält. Bei dieser bekannten Vorrichtung sind die Träger mit gegenseitigem Formschluß zu einem Turm aufeinandergestapelt, der ganz oder teilweise in eine benachbarte, einem Anleger zugeordnete Bestückungsposition bringbar ist, so daß der jeweils gewünschte Träger von oben zugänglich ist. Der jeweils nicht in die Bestückungsposiiton gebrachte Teil des Turms wird in der ursprünglichen Position zurückgehalten. Diese bekannte Vorrichtung benötigt daher eine dem Turm zugeordnete Entkopplungsvorrichtung, mittels welcher der nicht in die Bestückungsposition zu verbringende Teil des Turms außer Eingriff mit dem in die Bestückungsposition zu fahrenden Teil des Turms gebracht und in Position gehalten werden kann. Nachteilig ist auch, daß die Höhe des in die Bestückungsposition verbrachten Teils des Turms und damit der Höhenabstand zum Anleger von Fall zu Fall verschieden sind. Diese Anordnung erweist sich daher ebenfalls als nicht einfach und störungsfrei genug.

Hiervon ausgehend ist es daher die Aufgabe der vorliegenden Erfindung, eine Vorrichtung eingangs erwähnter Art zu schaffen, die einen einfachen und kompakten Aufbau aufweist und eine einfache Ausgestaltung der benötigten Steuerung ermöglicht sowie einen hohen Durchsatz gewährleistet.

Diese Aufgabe wird erfindungsgemäß durch das Kennzeichen des Anspruchs 1 gelöst.

Die erfindungsgemäßen Maßnahmen ermögichen praktisch eine Ringbewegung der Träger, indem die jeweils vorhandene Leerstelle mit einem benachbarten Träger besetzt wird, der an seiner ursprünglichen Position eine neue Leerstelle hinterläßt. Dies läßt sich fortsetzen, bis der jeweils gewünschte Träger in der Bestückungsposition ist. Auf diese Weise kann jeder Träger und damit jeder Plattenstapel schnell und sicher in die Bestückungsposition gebracht werden, wobei in vorteilhafter Weise lediglich vertikale und/oder horizontale Verschiebebewegungen durchzuführen sind. In Folge der erwähnten Ringbewegung der Träger ergeben sich in vorteilhafter Weise auch eine besonders einfache Gestaltung der zur Befehligung der Fördermittel benötigten Steuereinrichtung sowie ein kompakter Maschinenaufbau und damit insgesamt eine gute Wirtschaftlichkeit. Vorteilhafte Ausgestaltungen und zweckmäßige Fortbildungen der übergeordneten Maßnahmen sind in den Unteransprüchen angegeben und aus der nachstehenden Beispielsbeschreibung anhand der Zeichnung näher entnehmbar.

In der nachstehend beschriebenen Zeichnung zeigen:
- Figur 1: ein Funktionsschema einer erfindungsgemäßen Anordnung mit zwei Teilmagazinen in einer ersten Position,
- Figur 2: das Funktionsschema gemäß Figur 1 in einer weiteren Position,
- Figur 3: eine perspektivische Ansicht einer erfindungsgemäßen Anordnung mit einem zwei dreistöckige Teilmagazine aufweisenden Hochlager,
- Figur 4: eine Seitenansicht eines derartigen Hochlagers mit gegenüber Figur 3 variierten Fördermitteln,
- Figur 5: eine Draufsicht auf Figur 4 und
- Figur 6: eine schematische Ansicht eines als Flachlager ausgebildeten Beispiels.

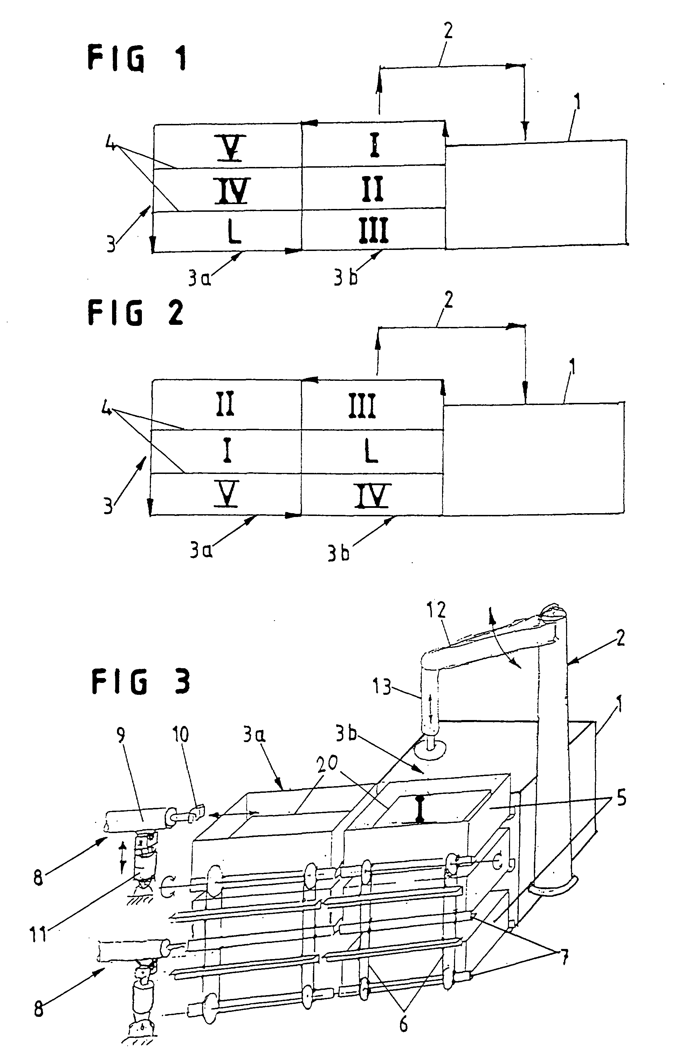

In dem den Figuren 1 und 2 zugrundeliegenden Funktionsschema ist eine beispielsweise mit einer Stanze zum Stanzen von Registerlöchern beginnende Bearbeitungsstraße 1 zur Herstellung von auf die Plattenzylinder von Druckmaschinen aufspannbaren Druckplatten angedeutet. Dieser Bearbeitungsstraße 1 werden die Plattenrohlinge mittels einer lediglich durch Bewegungspfeile angedeuteten Anlegers 2 zugeführt. Die Plattenrohlinge werden in Form von Plattenstapeln I - V bereitgehalten, wobei mehrere, unterschiedlichen Platten, z.B. Platten unterschiedlicher Größe, zugeordnete Plattenstapel, hier fünf Plattenstapel, vorgesehen sind.

Hierzu ist ein ein dem Anleger 2 zugeordnetes Plattenlager bildendes Plattenstapelmagazin 3 vorgesehen, das Stellplätze 4 für die Plattenstapel I - V enthält. Das Plattenstapelmagazin 3 enthält hier zwei einander benachbarte Teilmagazine 3a, b, die jeweils drei in Linie hintereinander angeordnete Stellplätze 4 aufweisen. Insgesamt ergeben sich somit sechs Stellplätze 4. Die Anzahl der vorhandenen Stellplätze 4 ist um eins größer als die Anzahl der vorhandenen Stapel I - V, so daß sich ein Leerraum L ergibt. Die Stellplätze 4 und damit auch die auf ihnen aufgenommenen Plattenstapel können innerhalb jedes Teilmagazins 3a, b senkrecht zur jeweiligen Stellebene verfahren werden. In der Darstellung gemäß Figuren 1 und 2 verläuft diese Verfahrbewegung von unten nach oben und umgekehrt, wie durch am rechten und linken Rand des Magazins 3 vorgesehene Bewegungspfeile angedeutet ist. Im Bereich der einander gegenüberliegenden Enden der Teilmagazine 3a, b, hier oben und unten, ist zusätzlich eine stellebenenparallele Stapelbewegung möglich, wie durch die im Bereich des oberen und unteren Rands des Magazins 3 gezeichneten Richtungspfeile angedeutet ist. Die vorstehend erwähnten stellflächennormalen und stellflächenparallelen Teilbewegungen ermöglichen, wie die Richtungspfeile anschaulich erkennen lassen, eine Ringbewegung der Plattenstapel.

Der Anleger 2 kann von einem der oberen Stapel jeweils eine Platte entnehmen und der Bearbeitungsstraße 1 zuführen. In den Figuren 1 und 2 ist der Anleger 2 dem rechten Teilmagazin 3b zugeordnet und entnimmt die Platten vom jeweils obersten Stapel dieses Teilmagazins. Der jeweils oberste Stapel des rechten Teilmagazins 3b befindet sich dementsprechend in der dem Anleger 2 zugeordneten Bestückungsposition. Das ist in der der Figur 1 zugrundeliegenden Betriebsstellung der Stapel I. Darunter befinden sich die Stapel II und III. Das linke Teilmagazin 3a enthält von oben nach unten die Stapel V und IV und ganz unten den Leerraum L.

Es kann nun vorkommen, daß auf eine Platte des Plattenstapels I beispielsweise eine Platte des Plattenstapels III folgen soll.

Dementsprechend muß der Plattenstapel III in die Bestückungsposition gebracht werden. Diese Stellung liegt der Figur 2 zugrunde.

Der Stellungswechsel erfolgt unter Durchführung des oben bereits erwähnten und durch die Richtungspfeile angedeuteten Ringlaufs, wobei der Leerraum L jeweils als Schieberaum dient.

Um ausgehend von der Betriebsstellung gemäß Figur 1 zur Betriebsstellung gemäß Figur 2 zu gelangen, werden zunächst die Plattenstapel IV und V um eine Stufe nach unten bewegt. Damit wird der in Figur 1 links unten vorhandene Leerraum L besetzt. Gleichzeitig entsteht jedoch links oben ein neuer Leerraum. Dorthin kann dann der Plattenstapel I gebracht werden, wodurch an dessen alter Stelle, also rechts oben, wieder ein neuer Leerraum entsteht. Dementsprechend können nun die Stapel II und III um eine Stufe nach oben bewegt werden, wodurch rechts unten ein neuer Leerraum entsteht. In diesen kann nun der Stapel IV eingefahren werden. Anschließend können die Stapel V und I um eine Stufe nach unten abgesenkt werden, wobei wiederum links oben ein Leerraum entsteht, in den nun der Stapel II von rechts nach links eingefahren werden kann. Anschließend wird der Stapel III um eine Stufe nach oben gefahren, womit sich dieser Stapel in der gewünschten Bestückungsposition befindet und die mittlere Stufe des rechten Teilmagazins 3b den Leerraum enthält. Auf diese Weise ist es möglich, jeden Stapel I bis V in die Bestückungsposition zu bringen.

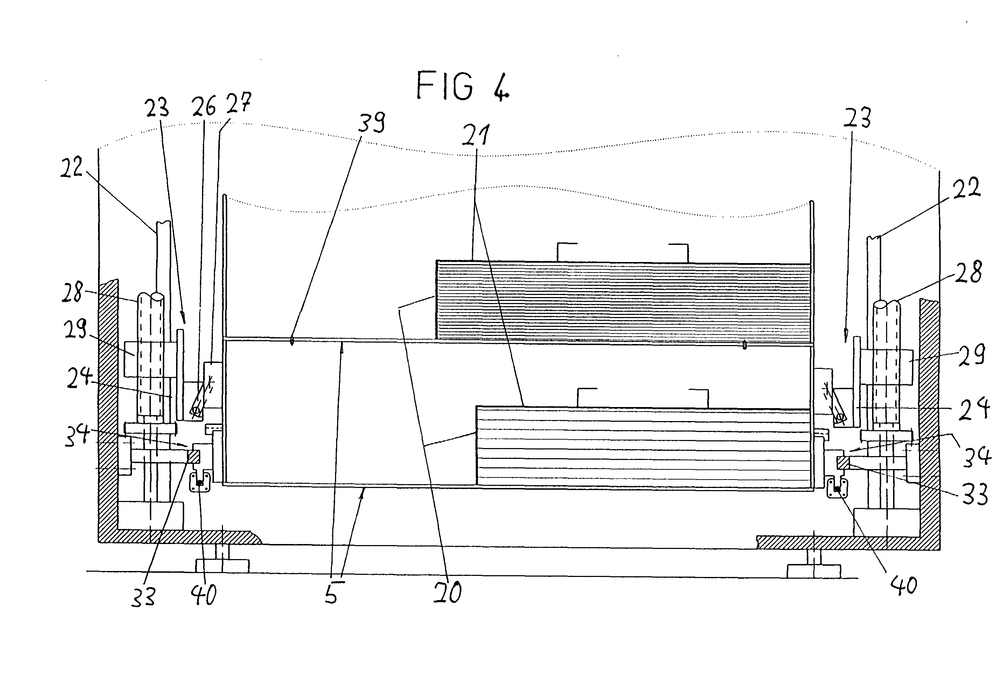

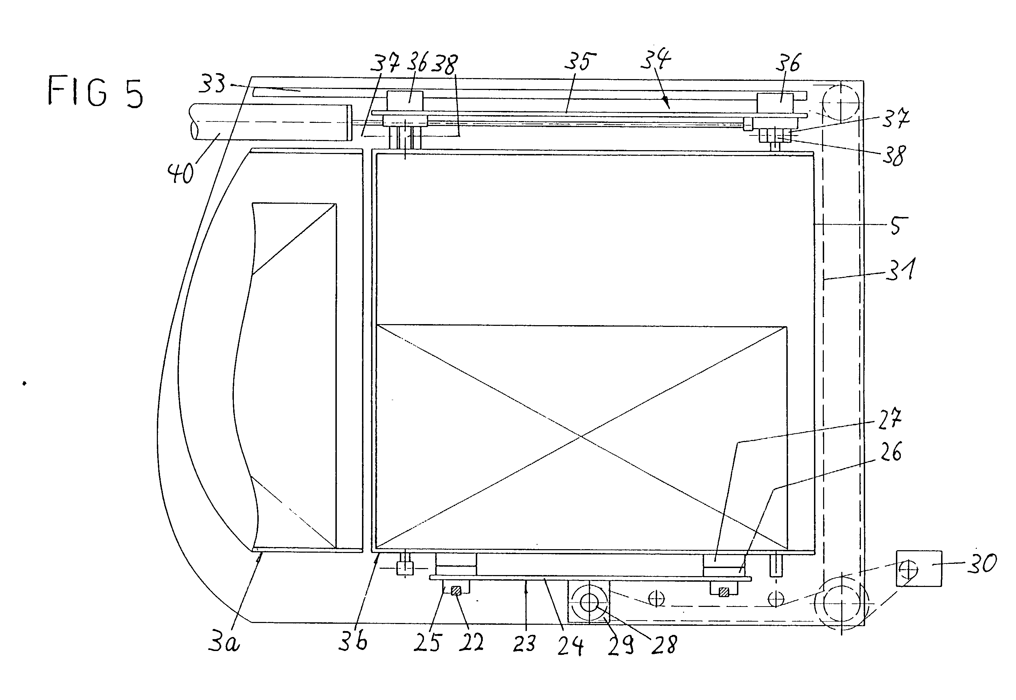

Den Stapeln, hier den Stapeln I - V, sind, wie die Figuren 3 bis 6 anschaulich zeigen, Träger 5 zugeordnet. Diese sind als Paletten mit einem Boden und einer zumindest teilweise umlaufenden Seitenwand ausgebildet. Zweckmäßig erstreckt sich die Seitenwand über lediglich drei Randkanten und ist im Bereich einer vierten Randkante weggelassen. Dies erleichtert die Beladung der Paletten. Eine derartige Ausführung liegt den Figuren 4 und 5 zugrunde. Bei den übrigen Beispielen ist eine umlaufende Seitenwand vorgesehen. Die Paletten werden mit kastenförmigen Kassetten 20 beladen, die jeweils einen zugeordneten Plattenstapel enthalten. Da die Platten lichtempfindlich sind, sind die Kassetten 20 jeweils mit einem in Figur 4 gezeigten, abnehmbaren Deckel 21 versehen. Der Deckel 21 der Kassette 20 des in der Bestückungsposition sich befindenden Trägers 5 wird abgenommen und nach Entnahme der benötigten Platte bzw. Platten wieder aufgelegt. Hierzu kann der Anleger 2 oder ein eigenes Deckelmanipulationsaggragat Verwendung finden.

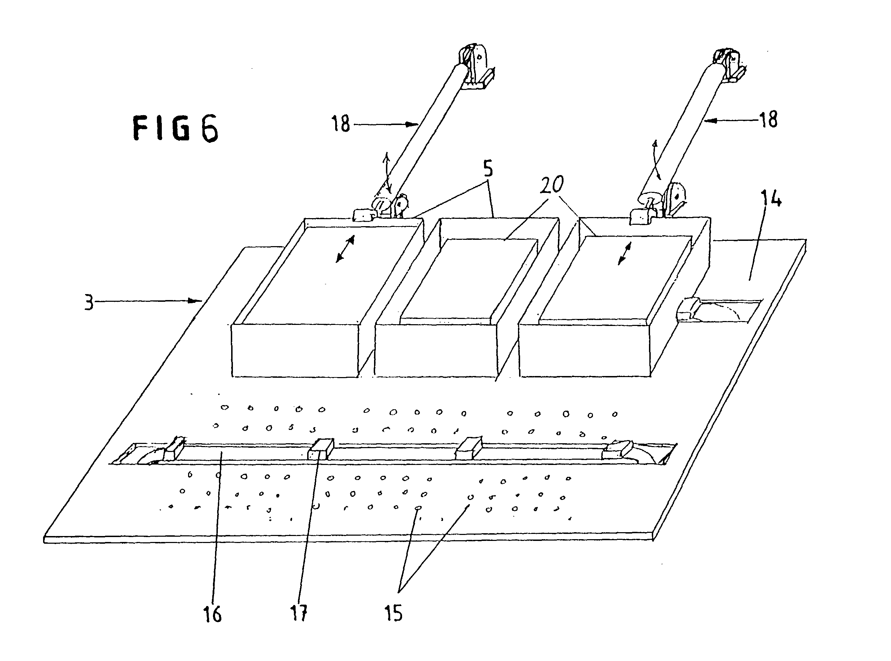

Die Anzahl der Träger 5 ist, wie oben bereits für die Anzahl der Stapel ausgeführt wurde, um eins kleiner als die Anzahl der vorhandenen Stellplätze 4, womit ein Stellplatz leer bleibt und sich damit der Leerraum L ergibt. Die Träger 5 werden in der oben für die Stapel beschriebenen Weise durch dem Magazin 3 zugeordnete Fördermittel bewegt, wobei die Bewegung in einer oder in zwei Ebenen erfolgen kann. Den Figuren 3 - 5 liegt eine Ausführung mit vertikaler und horizontaler Stapelbewegung zugrunde. Der Figur 6 liegt eine Anordnung mit lediglich horizontaler Stapelbewegung zugrunde.

Bei der Anordnung gemäß Figur 3 besteht das Magazin 3 aus zwei einander benachbarten, jeweils ein Teilmagazin 3a, b bildenden Schächten, in deren Bereich jeweils drei übereinander angeordnete Stellplätze für jeweils einen Träger 5 vorgesehen sind. Die Träger 5 sind innerhalb der Teilmagazine 3a, b in vertikaler Richtung transportierbar und können am oberen bzw. unteren Schachtende von jeweils einem Schacht zum benachbarten in horizontaler Richtung umgesetzt werden. Zur Bewerkstelligung der vertikalen Förderbewegung sind jedem Schacht zwei mit ihren Innentrums einander zugewandte, den zugeordneten Schacht flankierende Umlaufförderer 6 vorgesehen, die mit in geeignetem Abstand angeordneten Mitnehmern 7 versehen sind. Die einander paarweise gegenüberliegenden Mitnehmer 7 bilden jeweils einen Stellplatz für einen Träger 5. Die Mitnehmer 7 sind hier als Winkelschienen ausgebildet, so daß sich ein Tragschenkel und ein Führungsschenkel ergibt. Der Tragschenkel untergreift den zugeordneten Rand des aufzunehmenden Trägers 5. Der Führungsschenkel flankiert den aufzunehmenden Träger 5. Die auf jeweils zwei einander gegenüberliegenden Mitnehmern 7 der einander gegenüberliegenden Umlaufförderer 6 jedes Schachts aufgenommenen Träger 5 werden somit zuverlässig abgestützt und in Schienenlängsrichtung geführt. Der Abstand der Mitnehmer 7 ist größer als die Höhe der wannenförmigen Träger 5 bzw. der hierin aufnehmbaren Plattenstapel I - V.

Die Umlaufförderer 6 sind schrittweise antreibbar, wobei die Schrittlänge dem Abstand der Mitnehmer 7 entspricht. Die Antriebsrichtung kann, wie durch Richtungspfeile angedeutet ist, so erfolgen, daß die Träger 5 angehoben oder abgesenkt werden. Im Stillstand der Umlaufförderer 6 befinden sich die Mitnehmer 7 der den beiden einander benachbarten Schächten zugeordneten Umlaufförderer 6 fluchtend hintereinander. In dieser Stellung kann der dem Leerraum L benachbarte Träger 5 entlang der die Mitnehmer 7 bildenden Schienen in den Leerraum eingefahren werden.

Hierzu ist eine Horizontalfördereinrichtung vorgesehen, die zwei im Bereich der oberen bzw. der unteren Stufe der die Teilmagazine 3a, b bildenden Schächte in das Magazin 3 einfahrbare Schlepper 8 enthält, die in und außer Eingriff mit dem jeweils zu verschiebenden Träger 5 bringbar sind. Im dargestellten Beispiel enthalten die Schlepper 8 jeweils ein Zylinder-Kolbenaggregat 9, dessen ausfahrbare Kolbenstange am vorderen Ende einen mit dem zu verfahrenden Träger 5 zum Eingriff bringbaren, hier als am oberen Rand einer Seitenwand einhängbare Klaue ausgebildeten Eingriffskopf oder Mitnehmer 10 trägt. Um diesen in und außer Eingriff bringen zu können, ist das Zylinder-Kolbenaggregat 9 um eine horizontale Achse auf- und abschwenkbar angeordnet. Zur Bewerkstelligung der Schwenkbewegung ist ein hier ebenfalls als Zylinder-Kolbenaggregat ausgebildetes Huborgan 11 vorgesehen.

Der Anleger 2 kann, wie Figur 3 weiter zeigt, einen auf einem um eine vertikale Achse schwenkbaren Manipulator 12 aufgenommenen Hubsauger 13 enthalten. Dieser ist zweckmäßig als Teleskopsauger ausgebildet. Der Manipulator 12 kann als Kragarm einer Drehsäule ausgebildet sein.

Die Anordnung gemäß Figuren 4 und 5 entspricht hinsichtlich ihres grundsätzlichen Aufbaus der Anordnung gemäß Figur 3. Unterschiedlich sind die als linienparallele Förderer bzw. als quer dazu transportierende Schleppeinrichtungen fungierenden Vertikal-und Horizontalfördereinrichtungen zum Heben und Senken sowie zum Verschieben der Träger 5 zwischen den einander benachbarten, schachtförmigen Teilmagazinen 3a,b.

Die jedem Teilmagazin 3a,b zugeordnete Vertikalfördereinrichtung, die eine zur Achse des zugeordneten Teilmagazins 3a,b parallele und damit parallel zur Linie der hier übereinander angeordneten Träger 5 verlaufende Förderrichtung aufweist, enthält hier zwei bezüglich der Horizontalförderrichtung einander gegenüberliegende, auf jeweils zwei vertikalen, über die Magazinhöhe durchgehenden Führungsschienen 22 laufende Schlitten 23, welche das zugeordnete Teilmagazin flankieren, wie Figur 4 anschaulich zeigt. In Figur 5 ist aus Gründen der Übersichtlichkeit lediglich ein Schlitten 22 gezeichnet. Auf der diesem gegenüberliegenden Seite ist jedoch derselbe, hier nicht dargestellte Schlitten vorgesehen. Die Schlitten 23 besitzen jeweils eine zur benachbarten Magazinflanke parallele Lagerplatte 24. Diese ist auf ihrer vom Magazin abgewandten Außenseite mit Gleitschuhen 25 versehen, die mit den Führungsschienen 22 zusammenwirken, wie am besten aus Figur 5 erkennbar ist. Auf der den Lagerschuhen 25 gegenüber liegenden Innenseite ist die Tragplatte 23 mit mehreren, hier zwei steuerbaren Klinken 26 versehen. Die Träger 5 sind im Bereich ihrer Seitenflanken mit Stützvorsprüngen 27 versehen, mit denen die steuerbaren Klinken 26 in- und außer Eingriff gebracht werden können, wie am besten aus Figur 4 erkennbar ist. Die Stützvorsprünge 27 sind an den parallel zur Horizontalförderrichtung verlaufenden Seitenwänden der Träger 5 angebracht. Die offene Seite der Träger 5 verläuft daher quer hierzu, wie aus Figur 5 erkennbar ist.

Da die Klinken 26 steuerbar sind, können diese mit den Stützvorsprüngen 27 jedes der übereinander angeordneten Träger 5 zum Eingriff gebracht werden. Die Klinken 26 können einfach als elektromagnetisch betätigbare Klappen bzw. Schieber ausgebildet oder durch solche betätigbar sein, was die Steuerung erleichtert.

Jedem Schlitten 23 ist eine im Bereich zwischen den vertikalen Führungsschienen 22 angeordnete, über die Magazinhöhe durchgehende, vertikale Hubspindel 28 zugeordnet, die einen an der Lagerplatte 24 des zugeordneten Schlittens 23 befestigten Mutterkörper 29 durchgreift. Zur Erzielung einer besonders leichtgängigen Gewindeverbindung kann der Mutterkörper 29 mit einem Kugelumlaufgewinde versehen sein. Die beiden einander gegenüberliegenden Hubspindeln 28 jedes Teilmagazins 3a bzw. 3b sind, wie aus Figur 5 entnehmbar ist, mittels eines gemeinsamen Getriebemotors 30 antreibbar, der mit einem die beiden Hubspindeln 28 antriebsmäßig miteinander verbindenden, schlupffreien Vorgelege 31 zusammenwirkt, so dass ein exakter Synchronlauf beider Hubspindeln 28 gewährleistet ist. Das Vorgelege 31 kann als Zahnriementrieb ausgebildet sein, der besonders geräuscharm ist. Mittels des Getriebemotors 30, der ebenfalls steuerbar ist, können die Schlitten 23 in jede gewünschte Höhenposition und dementsprechend die Klinken 26 zum Eingriff mit den Stützvorsprüngen 27 jedes Trägers 5 des zugeordneten Teilmagazins 3a bzw. 3b gebracht werden.

Die im Bereich der oberen und unteren Trägerpositionen der beiden Teilmagazine 3a,b vorgesehenen Horizontalfördereinrichtungen enthalten jeweils zwei einander gegenüberliegende, durch parallel zur Horizontalförderrichtung verlaufende Führungsschienen 33 gebildete Führungen, die über beide einander benachbarte Teilmagazine 3a, b durchgehen. Auf den durch die Führungsschienen 33 gebildeten Führungen ist jeweils ein Schlitten 34 verfahrbar. In Figur 5 sind aus Gründen der Übersichtlichkeit wiederum lediglich eine Führungsschiene 33 mit zugeordnetem Schlitten 34 gezeichnet, obwohl auf der diesem gegenüberliegenden Seite dieselbe Anordnung vorgesehen ist, wie aus Figur 4 erkennbar ist.

Die Schlitten 34 besitzen jeweils eine zur benachbarten Magazinflanke parallele Tragplatte 35, die auf der vom Magazin abgewandten Außenseite zwei Gleitschuhe 36 trägt, die auf der zugeordneten Führungsschiene 33 aufgenommen sind. Zur Bildung einer Trägeraufnahme ist jede Tragplatte 35 mit zwei Prismen 37 versehen. Die Träger 5 sind mit seitlich abstehenden Rundbolzen 38 versehen, die in ein jeweils zugeordnetes Prisma 37 einsetzbar sind, wie am besten aus Figur 5 erkennbar ist. Jeweils zwei einander diagonal gegenüberliegende Prismen 37 und Rundbolzen 38 erstrecken sich rechtwinklig bzw. parallel zur Horizontalfördereinrichtung. Dies gewährleistet eine automatische Zentrierung und eindeutige Fixierung des jeweils aufgenommen Trägers 5 gegenüber der durch die Schlitten 34 gebildeten Horizontalfördereinrichtung und damit gegenüber der Maschine.

Zur Bewegung der Schlitten 34 sind diesen einerseits an einem Gleitschuh 36 und andererseits am Maschinengestell angreifende Hubzylinder 40 zugeordnet. Die Hubzylinder 40 der einander gegenüberliegenden Schlitten 34 sind selbstverständlich synchronisiert. Die Länge der Hubzylinder 40 ist so, dass ein dem gegenseitigen Versatz der einander benachbarten Teilmagazine 3a,b entsprechender Hub erzielbar ist. Anstelle von Hubzylindern könnten natürlich auch umlaufende Antriebseinrichtungen in Form von Ketten oder Zahnriemen etc. vorgesehen sein.

Zum Anheben bzw. Absenken eines Trägers 5 wird dieser von der Vertikalfördereinrichtung aufgenommen, indem die Klinken 26 zum Eingriff mit den Stützvorsprüngen 27 des betreffenden Trägers gebracht werden. Die Klinken 26 können wahlweise mit den Stützvorsprüngen 27 eines jeden der übereinander angeordneten Träger 5 zum Eingriff gebracht werden. Sofern die Klinken 26 an den Stützvorsprüngen 27 des obersten Trägers 5 angreifen, wird nur dieser angehoben. Sofern ein darunter sich befindender Träger 5 angehoben wird, wird durch diesen auch der hierauf abgesetzte Träger angehoben.

Zum Umsetzen eines Trägers 5 von einem Teilmagazin 3a zum benachbarten Teilmagazin 3b und umgekehrt, wird dieser Träger 5 auf die Schlitten 34 der oberen bzw. unteren Horizontalfördereinrichtung aufgelegt. Die Träger 5 werden immer von oben auf die darunter eingefahrenen bzw. wartenden Schlitten 34 aufgesetzt. In eine Leerstelle L können die Schlitten 34 ohne weiteres einfahren. Der in die Leerstelle L abgesenkte Träger 5 wird dabei auf die Schlitten 34 aufgesetzt. Sofern die Schlitten 34 in eine mit einem Träger 5 besetzte Position eingefahren werden sollen, wird der betreffende Träger 5 vorher mittels der Vertikalfördereinrichtung vorher soweit angehoben, dass die Schlitten 34 eingefahren werden können. Nachdem diese eingefahren sind, wird der betreffende Träger durch entsprechende Betätigung der Vertikalfördereinrichtung abgesenkt, bis seine Rundzapfen 38 zum Eingriff mit den Prismen 37 der eingefahrenen Schlitten 34 kommen.

Mehrere, übereinander sich befindende Träger 5 können, wie aus Figur 4 erkennbar ist, direkt aufeinander aufgesetzt werden, wobei zur Bewerkstelligung einer gegenseitigen Fixierung und Zentrierung Registerstifte 39 vorgesehen sind.

Zum Lösen von durch die Registerstifte 39 gegeneinander fixierten Trägern 5 wird jeweils ein Träger 5 soweit angehoben bzw. abgesenkt, dass die Registerstifte 39 außer Eingriff kommen. Dieser Hub entspricht praktisch dem oben erwähnten Hub zur Ermöglichung des Einfahrens der Schlitten 34. Zur Freigabe der Schlitten 34 wird ein hierauf aufgenommener Träger soweit angehoben, dass seine Rundzapfen 38 außer Eingriff mit den Prismen 37 der Schlitten 34 kommen. Nachdem diese einen Stellungswechsel ausgeführt haben, kann der vorher angehobene Träger 5 auf einen darunter sich befindenden Träger 5 abgesenkt werden, wobei die Registerstifte 39 in Eingriff kommen und eine gegenseitige Fixierung und Zentrierung gewährleisten.

Bei der Anordnung gemäß Figur 6 ist das Magazin 3 als Flachmagazin ausgebildet, wobei die Träger 5 in einer Ebene verschoben werden. Hierzu ist ein die Träger 5 aufnehmender Tisch 14 vorgesehen. Auf diesem sind zwei jeweils ein Teilmagazin bildende Stellplatzreihen mit jeweils drei Stellplätzen vorgesehen. Fünf der insgesamt sechs Stellplätze sind belegt, so daß sich wiederum ein Leerraum ergibt. In Figur 6 sind aus Gründen der Übersichtlichkeit lediglich die drei der hinteren Stellplatzreihe zugeordneten Träger 5 gezeichnet. Auf der vorderen Stellplatzreihe wären dementsprechend zwei Stellplätze belegt. Die diesbezüglichen Träger 5 sind weggelassen. Der Tisch 14 ist hier als Kugeltisch ausgebildet, in den Kugeln 15 eingelassen sind, auf denen die Träger 5 wiederstandsarm verschoben werden können. Es wäre auch denkbar, ein die Träger 5 abstützendes Luftpolster zu erzeugen. Hierzu können den Kugeln 15 zugeordnete, mit Druckluft beaufschlagbare Düsen vorgesehen sein, die geöffnet werden, sobald die betreffende Kugel durch einen Träger 5 niedergedrückt wird.

In den Tisch 14 sind zwei stellplatzreihenparallele, hier durch jeweils eine umlaufende Kette bzw. einen umlaufenden Riemen gebildete Umlaufförderer 16 eingelassen, die mit durch über die Tischebene vorspringende Klötze gebildeten Mitnehmern 17 versehen sind. Der lichte Abstand zwischen zwei einander benachbarten Mitnehmern 17 entspricht der Breite der Träger 5, so daß diese mit einander gegenüberliegenden Flanken an jeweils einem Mitnehmer 17 anliegen und dementsprechend versatzfrei transportierbar sind. Die Umlaufförderer 16 sind, wie die Umlaufförderer 6 der obigen Ausführung, schrittweise antreibbar, wobei ein Schritt einem Mitnehmerabstand entspricht. Durch die Umlaufförderer 16 wird die stellplatzreihenparallele Bewegung der Träger 5 bewerkstelligt.

Für die quer hierzu verlaufende Bewegung sind am vorderen und hinteren Ende der parallelen Stellplatzreihen angeordnete Schlepper 18 vorgesehen. Diese sind hier genauso aufgebaut, wie die oben bereits beschriebenen Schlepper 8 der Anordnung gemäß Figur 3, worauf zur Vermeidung von Wiederholungen Bezug genommen werden darf.

Die Bewegung der durch die Umlaufförderer 6 bzw. 16 und die Schlepper 8 bzw. 18 gebildeten Fördermittel müssen selbstverständlich aufeinander abgestimmt sein. Hierzu ist eine in den vorliegenden Zeichnungen nicht näher dargestellte Steuereinrichtung vorgesehen, durch die die genannten Fördermittel bzw. die diesen zugeordneten Antriebseinrichtungen befehligt werden. Die Steuereinrichtung besitzt zweckmäßig einen programmierbaren Speicher, in welchem die gewünschte Reihenfolge der Platten und davon abgeleitet die erforderliche Reihenfolge der einzelnen Bewegungen abgespeichert werden können. Durch entsprechende Betätigung der Fördermittel ist es dann möglich, dem Anleger 2 ohne jedes menschliche Dazutun die Platten in der richtigen Reihenfolge zuzuführen.

## Patentansprüche

1. Vorrichtung zur Bearbeitung von Druckplatten mit einem einer Bearbeitungsstation (1) zugeordneten Anleger (2), der die Platten in einer Bestückungsposition aufnimmt und der zugeordneten Bearbeitungsstation (1) zuführt, wobei dem Anleger (2) ein Plattenlager mit einem Plattenstapelmagazin (3) zugeordnet ist, das mehrere jeweils einen Plattenstapel aufnehmende Träger (5) enthält, von denen jeweils einer in der Bestückungsposition aufnehmbar ist und wobei das Plattenstapelmagazin (3) mit Fördermitteln ausgerüstet ist, mittels welcher jeder Träger (5) in die Bestückungsposition bringbar ist, **dadurch gekennzeichnet, dass** das Plattenstapelmagazin (3) wenigstens zwei einander benachbarte, jeweils mehrere in einer Linie angeordnete Stellplätze (4) für jeweils einen Träger (5) enthaltende Teilmagazine (3a,3b) aufweist, denen jeweils ein linienparalleler Förderer (6,16) und zwei quer hierzu über beide Teilmagazine (3a,3b) bewegbare Schleppeinrichtungen (8,18) zugeordnet sind, die im Bereich der einander gegenüberliegenden Enden der Teilmagazine (3a,3b) angeordnet sind, wobei die Anzahl der Träger (5) um eins kleiner als die Anzahl der vorhandenen Stellplätze (4) ist und daß die Träger (5) mittels der linienparallelen Förderer (6,16) und der Schleppeinrichtungen (8,18) um jeweils einen Stellplatzabstand transportierbar sind, wobei die durch die Förderer (6,16) und Schleppeinrichtungen (8,18) gebildeten Fördermittel mittels einer Steuereinrichtung steuerbar sind, die einen programmierbaren Speicher aufweist, in welchem die gewünschte Reihenfolge der Bewegungen ablegbar ist.

2. Vorrichtung nach Anspruch 1, **dadurch gekennzeichnet, dass** die Teilmagazine (3a,3b) als Schächte mit vorzugsweise jeweils drei übereinander angeordneten Stellplätzen ausgebildet sind, wobei jedem Teilmagazin (3a,b) eine einen linienparallelen Förderer (6) bildende Vertikalfördereinrichtung zugeordnet ist und wobei im Bereich der oberen und unteren Stellplätze der beiden Teilmagazine (3a,b) jeweils eine über beide Teilmagazine sich erstreckende,eine Schleppeinrichtung (8) bildende Horizontalfördereinrichtung vorgesehen ist.

3. Vorrichtung nach Anspruch 2 , **dadurch gekennzeichnet, dass** die über die beiden Teilmagazine (3a,b) sich erstreckenden Horizontalfördereinrichtungen jeweils zwei auf die beiden Teilmagazine (3a,b) flankierenden Führungen (33) geführte, mittels zugeordneter Linearantriebe bewegbare Schlitten (34) aufweisen, die mit Aufnahmemitteln (37) für einen mit Gegenaufnahmemitteln (38) versehenen Träger (5) versehen sind.

4. Vorrichtung nach Anspruch 3, **dadurch gekennzeichnet, dass** die Schlitten (34) mit die Aufnahmemittel (37) bildenden Prismen und die Träger (5) mit die Gegenaufnahmemittel (38) bildenden Rundbolzen versehen sind, wobei jeweils zwei einander diagonal gegenüberliegende Prismen und Rundbolzen parallel zur Horizontalförderrichtung verlaufen und die zwei weiteren, einander diagonal gegenüberliegenden Prismen und Rundbolzen quer dazu.

5. Vorrichtung nach einem der vorhergehenden Ansprüche, **dadurch gekennzeichnet, dass** die linienparallele, vorzugsweise vertikale Fördereinrichtung jeweils zwei das zugeordnete Teilmagazin (3a,3b) flankierende, mittels einer vorzugsweise als Spindeltrieb ausgebildeten Antriebseinrichtung antreibbare Schlitten (23) enthält, die mit steuerbaren Klinken (26) versehen sind, die zum Eingriff mit Stützvorsprüngen (27) der Träger (5) bringbar sind.

6. Vorrichtung nach Anspruch 2, **dadurch gekennzeichnet, dass** die linienparallelen Förderer als mit ihren einander zugewandten Innentrums den jeweils zugeordneten Schacht flankierende Umlauforgane (6) ausgebildet sind, deren gleichmäßig voneinander beabstandete Mitnehmer (7) als Tragschienen ausgebildet sind, wobei auf jeweils zwei einander gegenüberliegenden Tragschienen jeweils ein Träger (5) aufnehmbar und in Schienenlängsrichtung bewegbar ist und dass als Schleppeinrichtungen fungierenden Horizontalfördereinrichtungen als schienenparallel bewegbare Zylinder (9) mit Eingriffsköpfen (10) ausgebildet sind.

7. Vorrichtung nach Anspruch 1, **dadurch gekennzeichnet, dass** das Plattenstapelmagazin (3) einen Tisch (14) aufweist, auf dem mehrere parallele Stellplatzreihen vorgesehen sind, denen jeweils mindestens ein in den Tisch (14) eingelassener, eine linienparallele Fördereinrichtung bildender Umlaufförderer (16) zugeordnet ist, der über die Tischoberfläche vorspringende, gleichmäßig voneinander beabstandete Mitnehmer (17) aufweist und dass quer zur Laufrichtung der Umlaufförder (16) bewegbare, als mit Eingriffsköpfen versehene Zylinder (18) ausgebildete Schleppeinrichtungen vorgesehen sind.

8. Vorrichtung nach Anspruch 7, **dadurch gekennzeichnet, dass** der Tisch (14) als Kugeltisch ausgebildet ist und dass den Kugeln (15) mit Luft beaufschlagbare Düsen zugeordnet sind, die bei durch einen Träger (5) niedergedrückter Kugel geöffnet sind.

9. Vorrichtung nach einem der Ansprüche 6 - 8, **dadurch gekennzeichnet, dass** die Schleppeeinrichtungen (8,18) jeweils als ausfahrbarer, vorzugsweise gleichzeitig heb- und senkbarer, am vorderen Ende mit einem mit den Trägern (5) in und außer Eingriff bringbaren Eingriffkopf (10) versehener Arm ausgebildet sind.

10. Vorrichtung nach einem der vorhergehenden Ansprüche, **dadurch gekennzeichnet, dass** die Träger (5) als Paletten mit einem Boden und zumindest teilweise umlaufender Seitenwand ausgebildet sind.

## Claims

1. Device for the processing of printing plates, having a feeder (2), assigned to a processing station (1), which picks up the plates in a placement position and supplies them to the assigned processing station (1), with the feeder (2) assigned a plate store with a plate stack magazine (3) containing several carriers (5), each accommodating one plate stack, of which one can be picked up in the placement position at a time, and with the plate stack magazine (3) equipped with conveyor means by means of which each carrier (5) can be brought into the placement position, **characterized in that** the plate stack magazine (3) has at least two neighboring partial magazines (3a, 3b), each containing several placement positions (4), arranged in a line, for one carrier (5) at a time, which are each assigned one parallel conveyor (6, 16) and two dragging devices (8, 18), movable transverse to the conveyor over both partial magazines (3a, 3b), located in the region of the ends of the partial magazines (3a, 3b), which are opposite to one another, with the number of carriers (5) being one less than the number of placement positions (4) present, and the carriers (5) are transportable by means of the parallel conveyors (6, 16) and the dragging devices (8, 18) by a distance of one placement position at a time, with the conveyor means formed by the conveyors (6, 16) and dragging devices (8, 18) controllable by means of a control device having a programmable memory in which the desired sequence of movements can be stored.

2. Device according to claim 1, **characterized in that** the partial magazines (3a, 3b) are implemented as shafts, preferably each with three placement positions located on top of one another, with each partial magazine (3a, b) assigned a vertical conveyor device forming a parallel conveyor (6) and with a horizontal conveyor device provided in the region of each of the upper and lower placement positions of both partial magazines (3a, b) which extends over both partial magazines and forms a dragging device (8).

3. Device according to claim 2, **characterized in that** the horizontal conveyor devices extending over both partial magazines (3a, b) each have two slide carriages (34), movable by means of assigned linear drives and guided on the two guides (33) flanking the two partial magazines (3a, b), which are provided with receiver means (37) for a carrier (5) provided with counter receiver means (38).

4. Device according to claim 3, **characterized in that** the slide carriages (34) are provided with the prisms forming the receiver means (37) and the carriers (5) are provided with the round bolts forming the counter receiver means (38), with two prisms and round bolts lying opposite to one another running parallel to the direction of horizontal conveyance at a time and the two further prisms and round bolts lying opposite to one another running transverse to this direction.

5. Device according to one of the preceding claims, **characterized in that** the parallel, preferably vertical conveyor device contains two slide carriages (23), which flank the assigned partial magazine (3a, 3b) and can be driven by a drive device preferably implemented as a jackscrew actuator, which are provided with controllable ratchets (26) that can engage with support projections (27) of the carriers (5).

6. Device according to claim 2, **characterized in that** the parallel conveyors are implemented as rotating organs (6), flanking the respective assigned shaft with their facing inner conveyor surfaces, whose uniformly spaced drivers (7) are implemented as carrier rails, with one carrier (5) at a time able to be picked up and moved in the longitudinal direction of the rails on each two opposite carrier rails, and the horizontal conveyor devices functioning as dragging devices, implemented as cylinders (9) with contact heads (10), movable parallel to the rails.

7. Device according to claim 1, **characterized in that** the plate stack magazine (3) has a table (14) on which several parallel rows of placement positions are provided, each of which is allocated at least one rotating conveyor (16), embedded in the table (14) and forming a parallel conveyor device, which has uniformly spaced drivers (17) projecting above the table surface, and dragging devices, implemented as cylinders (18) provided with contact heads, which are movable transverse to the operating direction of the rotating conveyor (16) are provided.

8. Device according to claim 7, **characterized in that** the table (14) is implemented as a ball table and the balls (15) are assigned nozzles, capable of being supplied with air, which are opened when a ball is pressed down by a carrier (5).

9. Device according to one of the claims 6-8, **characterized in that** the dragging devices (8, 18) are each implemented as a telescoping arm, preferably also able to be raised and lowered, which is provided on its forward end with a contact head (10) that can engage and disengage with the carriers (5).

10. Device according to one of the preceding claims, **characterized in that** the carriers (5) are implemented as pallets with a floor and an at least partially surrounding side wall.

## Revendications

1. Dispositif de traitement de plaques d'impression, comprenant un dispositif d'alimentation (2) associé à une station de traitement (1), qui reçoit les plaques dans une position d'équipement et les amène à la station de traitement associée (1), audit dispositif d'alimentation (2) étant associé un dépôt de plaques avec un magasin de piles de plaques (3) qui comprend plusieurs supports (5) reçevant respectivement une pile de plaques, dont respectivement un peut être reçu dans la position d'équipement, et ledit magasin de piles de plaques (3) étant muni de moyens de transport au moyen desquels chaque support (5) peut être mis dans la position d'équipement, **caractérisé par le fait que** le magasin de piles de plaques (3) présente au moins deux magasins partiels (3a, 3b) voisins l'un de l'autre qui comprennent respectivement plusieurs emplacements (4) disposés sur une ligne pour respectivement un support (5) et auxquels sont associés respectivement un convoyeur (6, 16) parallèle à la ligne ainsi que deux dispositifs de traînage (8, 18) qui peuvent être déplacés transversalement à cela sur les deux magasins partiels (3a, 3b) et qui sont disposés dans la zone des extrémités opposées des magasins partiels (3a, 3b), le nombre des supports (5) étant plus petit d'un que le nombre des emplacements (4) existants, et que les supports (5) peuvent être transportés au moyen des convoyeurs (6, 16) parallèles à la ligne et des dispositifs de traînage (8, 18) de respectivement une distance d'emplacement, les moyens de transport formés par les convoyeurs (6, 16) et par les dispositifs de traînage (8, 18) pouvant être commandés par le biais d'un dispositif de commande qui présente une mémoire programmable dans laquelle la suite souhaitée des mouvements peut être mémorisée.

2. Dispositif selon la revendication 1, **caractérisé par le fait que** les magasins partiels (3a, 3b) sont réalisés comme puits avec respectivement trois emplacements disposés l'un au-dessus de l'autre, à chaque magasin partiel (3a, b) étant associé un transporteur vertical formant un convoyeur (6) parallèle à la ligne, et un transporteur horizontal s'étendant sur les deux magasins partiels et formant un dispositif de traînage (8) étant prévu respectivement dans la zone des emplacements supérieurs et inférieurs des deux magasins partiels (3a, b).

3. Dispositif selon la revendication 2, **caractérisé par le fait que** les transporteurs horizontaux s'étendant sur les deux magasins partiels (3a, b) présentent respectivement deux glissoirs (34) qui sont guidés sur des glissières (33) flanquant les deux magasins partiels (3a, b), peuvent être déplacés au moyen de mécanismes d'entraînement linéaire associés et sont pourvus de moyens de réception (37) pour un support (5) muni de contre-moyens de réception (38).

4. Dispositif selon la revendication 3, **caractérisé par le fait que** les glissoirs (34) sont pourvus de prismes formant les moyens de réception (37) et que les supports (5) sont pourvus de boulons ronds formant les contre-moyens de réception (38), respectivement deux prismes et boulons ronds diagonalement opposés s'étendant parallèlement à la direction horizontale de transport et les deux autres prismes et boulons ronds diagonalement opposés s'étendant transversalement à cela.

5. Dispositif selon l'une des revendications précédentes, **caractérisé par le fait que** le convoyeur parallèle à la ligne, de préférence vertical comprend respectivement deux glissoirs (23) qui flanquent le magasin partiel associé (3a, 3b), peuvent être entraînés au moyen d'un dispositif d'entraînement réalisé de préférence comme commande à vis sans fin et qui sont pourvus de cliquets (26) qui peuvent être commandés et être mis en prise avec des projections d'appui (27) des supports (5).

6. Dispositif selon la revendication 2, **caractérisé par le fait que** les convoyeurs parallèles à la ligne sont réalisés comme organes circulants (6) qui, avec leurs brins intérieurs montrant l'un vers l'autre, flanquent le puits respectivement associé et dont les entraîneurs (7) disposés à distance régulière l'un de l'autre sont réalisés comme rails porteurs, respectivement un support (5) pouvant être reçu sur respectivement deux rails porteurs placés en regard l'un de l'autre et pouvant être déplacé dans la direction longitudinale des rails, et que des transporteurs horizontaux faisant fonction de dispositifs de traînage sont réalisés comme cylindres (9) pourvus de têtes de prise (10), qui peuvent être déplacés parallèlement aux rails.

7. Dispositif selon la revendication 1, **caractérisé par le fait que** le magasin de piles de plaques (3) présente une table (14) sur laquelle sont prévues plusieurs rangées parallèles d'emplacements auxquelles est associé respectivement au moins un convoyeur circulaire (16) qui est inséré dans ladite table (14) et forme un transporteur parallèle à la ligne et qui présente des entraîneurs (17) dépassant la surface de la table et disposés à distance régulière l'un de l'autre, et que l'on prévoit des dispositifs de traînage qui peuvent être déplacés transversalement à la direction de marche des convoyeurs circulaires (16) et qui sont réalisés comme cylindres (18) munis de têtes de prise.

8. Dispositif selon la revendication 7, **caractérisé par le fait que** la table (14) est réalisée comme table à billes et que des buses qui peuvent être alimentées en air et qui sont ouvertes lorsque la bille est abaissée par un support (5) sont associées aux billes (15).

9. Dispositif selon l'une des revendications 6 à 8, **caractérisé par le fait que** les dispositifs de traînage (8, 18) sont réalisés respectivement comme bras télescopique qui, de préférence, peut être en même temps levé et abaissé, et qui, à l'extrémité avant, est pourvu d'une tête de prise (10) qui peut être mise en prise et hors prise avec les supports (5).

10. Dispositif selon l'une des revendications précédentes, **caractérisé par le fait que** les supports (5) sont réalisés comme palettes avec un fond et avec une paroi latérale au moins en partie circonférentielle.
